# EUROPEAN PATENT APPLICATION

(11) **EP 3 157 061 A1**
(43) Date of publication of application: **19.04.2017**
(21) Application number: 15190177.4
(22) Date of filing: 16.10.2015
(51) Int. Cl.: H01L 31/0224, H01L 31/032, H01L 31/08, H01L 31/108

(54) **PHOTODIODE WITH INTENSE PHOTOVOLTAGE OR PHOTOCURRENTS**

(71) Applicant: Fundacio Privada Institut Catala de Nanociencia I Nanotecnologia (ICN2), 08193 Bellaterra (Barcelona) (ES); Consejo Superior de Investigaciones Cientificas (CSIC), 28006 Madrid (ES); Institució Catalana De Recerca I Estudis Avançats (ICREA), 08010 Barcelona (ES)
(72) Inventor: LIRA-CANTU, Mónica, 08193 CERDANYOLA DEL VALLÈS (Barcelona) (ES); PÉREZ TOMÁS, Amador, 08193 CERDANYOLA DEL VALLÈS (Barcelona) (ES); CATALÁN BERNABÉ, Gustau, 08193 CERDANYOLA DEL VALLÈS (Barcelona) (ES)
(74) Representative: Carpintero Lopez, Francisco

(57) **Abstract**

Photodiode comprising a transparent fluorine-doped tin oxide (FTO) layer, an active layer of a wide-bandgap semiconductor and an ionizable metal electrode, in which the active layer has been oxidized for 1-10 minutes at a temperature between 600° and 625°. The photodiode thus manufactured has the highest photovoltaic field ever observed in a photovoltaic device. This enormous (MV/cm) photovoltaic field makes unprecedented above-bandgap voltages viable for very thin (less than 1 µm) thin-film devices.

## Description

### BACKGROUND OF THE INVENTION

### Field of the Invention

The present invention relates to power photovoltaics. More in particular, the invention concerns a photodiode and fabrication method thereof, where the photovoltage or photocurrent is improved by means of a combination of wide-bandgap semiconductor materials with particular electrodes, and a novel process for its manufacture.

### Description of the Related Art

To date, the photovoltaic effect has been studied in lithium niobate (LiNbO₃), barium titanate (BaTiO₃ or BTO), lead zirconatetitanate (Pb(ZrTi)O₃ or PZT) and bismuth ferrite (BiFeO₃ or BFO) and their families. These materials provide viable routes for converting light into electric energy. Large photo-induced voltages have been reported, for example by Kui Yao et al., "Large photo-induced voltage in a ferroelectric thin film with in-plane polarization", Applied Physics Letters, 87 (2005). In this letter, a PLWZT ferroelectric film with a thickness of 0.42 µm was prepared on a silicon wafer and poled along the surface plane with gold electrodes on top of the film. The resulting photovoltage was about 7 V. The voltage, although larger than the bandgap, only represents a photovoltaic field of 2.8 kV/cm (very conventional when compared with a p-n junction), since the spacing between electrodes is 25 µm. Larger voltages were reportedly achieved by using a larger gap between electrodes. This known device has a so-called lateral configuration, that is, a configuration where both electrodes (cathode and anode) are located on top and the illumination reaches the active area between the electrodes also from the top. The lateral configuration is typical of devices grown on non-transparent substrates such as silicon.

However, such lateral configuration is much less efficient than a vertical photodiode because the area consumption is much larger than in a vertical photodiode configuration. Having both electrodes on top is also a significant drawback because of material consumption and complex topology when integrated in modulus. There is thus a need for vertical photodiodes with improved photovoltages or photocurrents while keeping the active area as thin as possible.

### SUMMARY OF THE INVENTION

It is, therefore, an object of the present invention to provide a vertical photodiode with large photo-induced voltages and photocurrents.

These and other objects are achieved by a photodiode comprising a transparent fluorine-doped tin oxide (FTO) layer, an active layer of a wide-bandgap semiconductor and an ionizable metal or a metal which interface with the active layer is ionizable in which the active layer has been very rapidly and straightforward annealed for 30s-30 minutes at a temperature between 600°C and 625°C in a conventional furnace in air, with no further oxidation treatment in O₂. However, oxidation can improve some features of the final active area.

The active layer comprises one or a mixture of the following compounds: lead zirconate titanate (Pb(ZrTi)O₃ or PZT), YMnO₃ (YMO), BiFeO₃ (BFO), PbZrO₃ (PZO). These ferroelectric and anti-ferroelectric compounds are all wide-bandgap semiconductors in which the dipoles are orientable. Thanks to this property the electric field within the thin-film can be orders of magnitude higher than in a *p-n* junction and therefore large above-bandgap voltages can be achieved in thin-films (below 1 µm). To date no above-bandgap voltages has been reported in vertical thin-film photodiodes. The active layer is coated on fluorine-doped tin oxide (FTO). The top electrode comprises ionizable metal. The photodiode is fabricated from liquid solutions, and therefore different printing methods can be applied for its manufacture. Photodiodes with very large photocurrent are obtained if the thickness of the active area thin-film is reduced from nominal 900 nm (three spin coating cycles, i.e., 3L) to 300 nm (one single spin coating cycle, i.e., 1 L). The photodiode internal field for the 1L photodiode extends in the entire thin-film resulting in a *punch-through* photodiode where very large photocurrents are obtained. The device has further use as a self cleaning surface.

### BRIEF DESCRIPTION OF THE DRAWINGS

To complete the description and provide for better understanding of the invention, a set of drawings is provided. Said drawings illustrate a preferred embodiment of the invention, which should not be interpreted as restricting the scope of the invention, but just as an example of how the invention can be carried out.
**Figure 1** shows a cross section of a device in accordance with an embodiment of the invention.
**Figure 2** is a graph showing the photovoltage achieved by the invention when comprising a PZT (ferroelectric) or PZO (antiferroelectric) active layer compared to the photovoltage of a prior art device under the same conditions.
**Figure 3** is a graph showing the photovoltaic electric field improvement of two orders of magnitude when comparing the invention with the prior state of the art. The outstanding enhancement lies in the use of vertical (instead of lateral) structures and the use of ferroelectric/antiferroelectric internal fields.
**Figure 4** shows the experimental current-voltage results for an average PZT and PZO 3L photodiode (in the dark and under illumination) illustrating the large above-bandgap voltages and the outstanding related photovoltaic fields.
**Figure 5** shows typical ferroelectric (PZT) and antiferroelectric (PZO) hysteresis loops or polarization vs. voltage graphs. The internal orientable dipoles are on the basis on the invention.
**Figure 6** shows the current density output for the photodiode 3L (three spin coating cycles) (900 nm) and 1L (one spin coating cycle) (300 nm). It is shown how the invention improves the current density many orders of magnitude when biased at a very small bias (0.1 V), in particular for 1 L.
**Figure 7** shows the experimental current-voltage characteristics of a 1 L PZT photodiode showing large photocurrent which results in a photodiode with high gain.
**Figure 8** shows the well-known on-resistance vs. breakdown voltage factor of merit diagram for a power switch device and how the 1 L device compares well with the state of the art. Nevertheless, 1 L photodiode is a polycrystalline, low-cost and straightforward device made outside a cleanroom.

### DESCRIPTION OF THE INVENTION

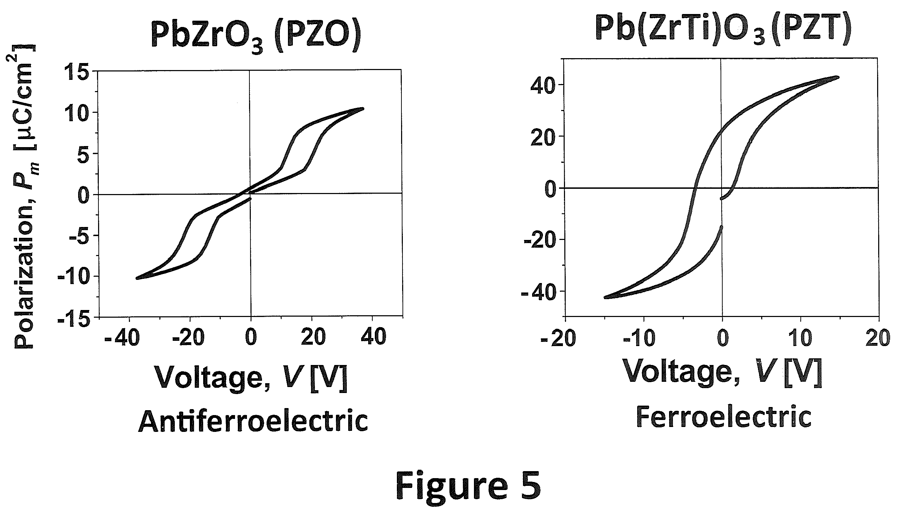

The experimental photovoltages obtained by the invention are 120 V and 70 V (Fig. 5) for the PZT and PZO as active layer, respectively. Therefore, the photovoltaic fields are 1.2 MV/cm and 780 kV/cm, respectively (layer thickness is 900 nm). This is the largest photovoltaic field ever observed and due to its magnitude and its presence in a thin-film it is conceivable that its application goes beyond the photovoltaic.

The fabrication method according to the invention requires the annealing in air of the active layer at high temperatures (600°C-625°C) for a very short period of time of 30s to 30 minutes so the conductivity of the FTO is not affected. Nevertheless, some limited Sn interdiffusion takes place at the FTO/active layer enabling this contact to be non-barrier limited, i.e., Ohmic in nature. This fact is fundamental for the achievement of high performance devices. The annealing is performed in air in a conventional oven. Some additional steps can be performed to improve the device performances; in particular, post-annealing oxidation in O₂ (550C-625°C) can improve the active layer morphology.

Photovoltaic devices with large output voltage will enable higher power conversion efficiency in tandem solar cells stacked with the present invention (Glass/FTO/Active Area/ionizable metal/semiconductor/metal). An ionizable metal is required to be on top of the active area as ionization of metal enables the large internal field to be created within the ferroelectric. The semiconductor can be one or a combination of the following: metal-halide perovskites such as methylammonium (lead or tin), (iodide,bromide or chloride) [CH₃NH₃] XY₃) where X is Pb or Sn and Y is I, Br or Cl, organic photovoltaic semiconductor blends such as the regioregular poly (3-hexylthiophene) (P3HT) and phenyl-C61-butyric acid methyl ester (PCBM) or P3HT:PCBM, NiO, V2O5, WO3, MoO3, ZnO or TiO₂. The top metal is not restricted to be an ionizable material and can be Ag, Au, Pt, graphite or Al.

The resulting vertical power photovoltaic photodiode made through (out-plane or top-bottom) a thin-film on glass/transparent electrode/active area/metal, having a thickness lower than 1 µm, is therefore based on the photo-orientable polarization of (anti)ferroelectric active layers and produces record high photovoltaic fields over 1MV/cm by a combination of a low-resistance drift layer and high-resistance diffusion layer. The large photovoltaic field (whose equipotentials extend the photodiode outside limits) can be used as adisinfection or catalytic surface and electrostatic precipitator of ionized and polar particles at the microscale.

The photovoltaic field is also accompanied by a notable photostrictive (non-thermal light-induced shape changes) effect on the thin-film which can be used as well as self-cleaning surfaces. The combination of high voltage, high photovoltaic fields, small size and photostrictive effect makes this present invention ideally suited for future power electronics controlled by light. The present invention is suitable for the future generation of wireless remote control photo-actuators, micro-actuators and micro-sensors.

Photodiodes with very large photocurrent are obtained if the thickness of the active area thin-film is reduced from 900 nm (three spin coating cycles, i.e., 3L) to 300 nm (one single spin coating cycle, i.e., 1 L). The photodiode internal fields for 1 L extend the entire thin-film resulting in a *punch-through* photodiode where instead of achieving large photovoltages, very large photocurrents are obtained. The condition to achieve a large voltage is the series combination of a low resistive drift region (depleted region due to the photovoltaic field) and a highly resistive region. When the device becomes thinner (i.e. one single layer instead of three but with identical processing and structure), the photovoltaic field encompasses all the device area so any photogenerated carrier is accelerated without the limitation of any contact barrier.

Commercial materials were used without further purification in the fabrication of the following devices in accordance with embodiments of the invention.

### Ferroelectric PZT Photodiode

For an active layer, the Ti thin film precursor was titanium isopropoxide, Ti[OCH-(CH₃)₂]₄ (97%), the Zr thin film precursor was a zirconium(IV) propoxide solution, Zr[OCH(CH₃)₂]₄ (70 wt. % in 1-propanol) and the Pb precursor as lead (II) acetate trihydrate, Pb(CH₃CO₂)₂•3H₂O (99.999%), all from Sigma-Aldrich. All aqueous solutions were prepared using double distilled and ion-exchange water.

The FTO substrates of 1.1 mm thickness, (70-100 ohm resistance, thickness of FTO layer 800 Å) were cleaned with soap water, Milli-Q water, ethanol (99.5%) for 20 min before use.

### PZT Preparation of solutions

PZT synthesis was done as follows: 3.53 g of Zr-isopropoxide were added into a beaker. Then, 1.96 g of Ti-isopropoxide were added and mixed. Afterwards, 5 ml of acetic acid and 10 ml of n-propanol were added to the Zr/Ti solution. Afterwards, Pb acetate (5.95 g - 10% excess) was dissolved into the above solution heating the solution in a silicon oil bath to 85°C for dissolving the Pb precursor completely. After the cooling down of the solution, 10 ml of acetic acid and 2 ml of distilled water were added to modify the Pb-Zr-Ti solution and adjust the solution to make 40 ml 0.4 M. The solution was aged for 24h before use.

### PZT Photodiode fabrication

The FTO substrates were bought from Solems, model ASAHI 100 by CVD of 1.1 mm thickness (70-100 ohm resistance, thickness of FTO layer 800 Å), and were cleaned with soap water, Milli-Q water, ethanol (99.5%) for 20 min before use. For the etching of the FTO substrates: Zn powder (≥99%, Aldrich) and hydrochloric acid (HCl) (ACS reagent 37% from Sigma Aldrich). After a UV light cleaning step for 20 minutes, 80 µl of PZT solution were spin-coated on top of the FTO at 4000 rpm with an acceleration of 2000 rpm for 40s. The solution was dried on the hot plate for 5 min at 150°C; the PZT layer was annealed at 600-625°C for 30s -30 min in air. The spin coating process is repeated three times resulting in films of 900 nm. For some of the samples, an additional oxidation (550°C-650°C) was performed for 30s -2 hours in oxygen, which improves some of the characteristics of the active layer. The anode metal (ionizable metal) is deposited (evaporation) after ferroelectric growth without any cleaning step. The anodes of the device defined by means of a shadow mask are circular dots with 100 µm, 200 µm and 400 µm in diameter. A ferroelectric characterization system (Radiant RT66) was used to measure polarization-voltage (P-V) loops and to determine the main ferroelectric PZT properties.

### Antiferroelectric PZO Photodiode

Identically, for the PZO active layer, the Zr thin film precursor was a zirconium (IV) propoxide solution, Zr[OCH(CH₃)₂]₄ (70 wt. % in 1-propanol) and the Pb precursor as lead (II) acetate trihydrate, Pb(CH₃CO₂)₂•3H₂O (99.999%), all from Sigma-Aldrich.

All aqueous solutions were prepared using double distilled and ion-exchange water.

The FTO substrates of 1.1 mm thickness, (70-100 ohm resistance, thickness of FTO layer 800 Å) were cleaned with soap water, Milli-Q water, ethanol (99.5%) for 20 min before use.

### PZO Preparation of solutions

Identically, for PZO synthesis the Ti precursor step was avoided. The Zr molar weight was recalculated to be 1:1 with Pb and all the rest of the process was maintained identical. PZO synthesis was done as follows: 5.36 g of Zr-isopropoxide were added into a beaker. Afterwards, 5 ml acetic acid and 10 ml of n-propanol were added to the Zr solution. Afterwards, Pb acetate (5.95 g - 10% excess) was dissolved into the above solution heating the solution in a silicon oil bath to 85°C for dissolving the Pb precursor completely. After the cooling down of the solution, 10 ml of acetic acid and 2 ml of distilled water were added to modify the Pb-Zri solution and adjust the solution to make 40 ml 0.4 M. The solution was aged for 24h before use.

### PZO Photodiode fabrication

PZT and PZO photodiode fabrication and characterization were completely identical. A ferroelectric characterization system (Radiant RT66) was used to measure polarization-voltage (P-V) loops and to determine the main antiferroelectric PZO properties. An antiferroelectric (AFE) phase turns into ferroelectric (FE) phase as the result of an adequate electric field stress, temperature stress or hydrostatic pressure. In an AFE to FE transition, dipoles re-align in the same orientation within a domain.

### PZT 1L Photodiode fabrication

PZT and PZO 1 L photodiode fabrication and characterization were completely identical but instead of repeating the spin coating process three times, it is only performed once. The solution used for the spin coating, the photodiode fabrication process and the characterization are identical for 3L and 1 L. The only difference is that 3 spin coatings were performed in 3L and just one spin coating cycle was performed in 1 L. Ferroelectric PZT coercive voltage scales properly with the variation in thickness. Analogously, the voltage required for the AFE to FE transition is larger for 3L devices (14-30 V) when compared to 1 L devices (2-5 V). However, in both cases, this voltage corresponds to approximately an electric field of 100-300 kV/cm.

### Characterization

**X-ray powder diffraction (XRD)** analyses were performed between 5 and 120 degrees in a RIGAKU Rotaflex RU200 Binstrument, using CuKα1 radiation using an Asylum MFP3D atomic force microscope (AFM) working in non-contact mode.
**The UV-visible** analyses of solutions and thin films were performed in a Shimadzu 1800 spectrophotometer. UV-vis spectroscopy was used to determine the Lambert-Beer absorption coefficient to be α₃₆₅ =3.4 × 10³ cm⁻¹.

**The UV-LED** measurements were carried out in a home-made set-up attached to a probe station. The UV-LED source is a commercial UV LED from Roithner part APG2C1-365-E 1W 365 nm. I-V curves were measured with a Keithley model 6430 Sub-Femtoamp Remote Source Meter. The nominal 365 nm UVA-LED irradiance has been precisely determined to be *I_{c}*=159.1 W/m² with a spectrophotometer at the exact distance with the irradiation peak centered at 369.2 nm and a FWHM of Δλ*ₚ*=9.6 nm.

**The ferroelectric** characterization was performed with a precision LC tester LCII Ferroelectric Test System unit by Radiant Technologies attached to a probe station.

**Spectral Irradiance** measurements were performed with a SPECTRO 320 (D) release 5 spectrophotometer, 30932004, with gadget EOP-146 to measure spectral irradiance. Spectral irradiance has been measured out-of-plane (90°) with a scan step of 1 nm and a speed of 100 ms/nm.

### Experimental results

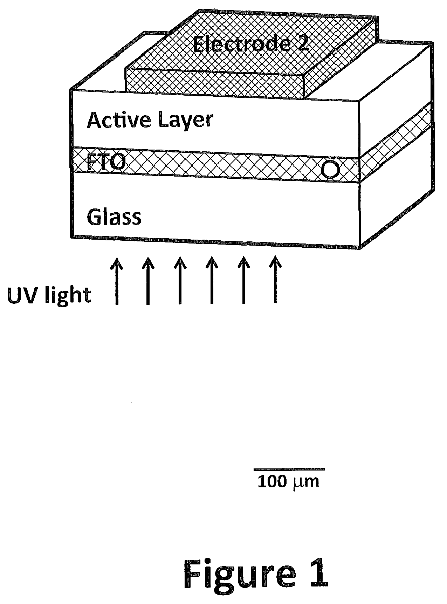

**Figure 1** shows a cross section of a device in accordance with an embodiment of the invention.

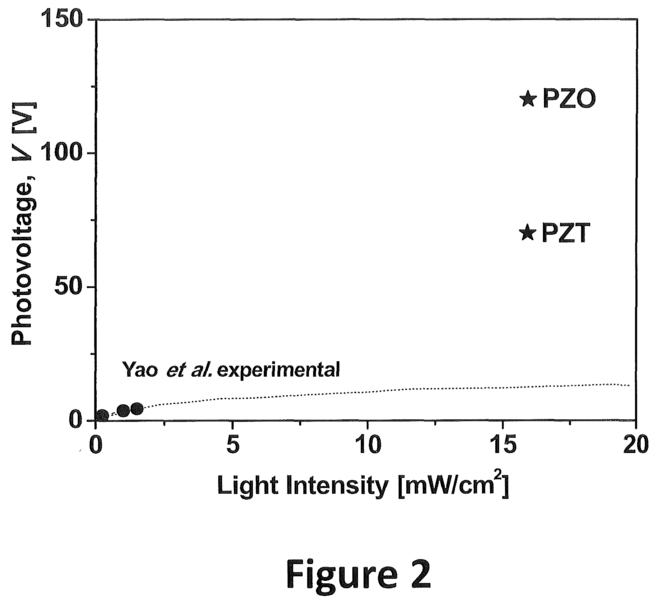

**Figure 2** shows the photovoltage of the invention as compared to the photovoltage of a prior art photodiode as in Kui Yao above. It demonstrates a very large photovoltage of 70V for PZT (ferroelectric) and 120V for PZO (antiferroelectric). This is a 10-fold improvement in the largest photovoltage value reported by Kui Yao. For a fair comparison, the experimental photovoltage vs. light intensity has been extended for the same light intensity (irradiance) as published in "Large photo-induced voltage in a ferroelectric thin film with in-plane polarization", Applied Physics Letters, 87 (2005). For the same light intensity, the present invention still has 7-9 times larger photovoltages. The experimental photovoltages are well above the bandgap voltage of PZT or PZO that lies in the range of 3-4 eV. More relevant is the photovoltaic field enhancement when photovoltaic field is analyzed instead of the photovoltage. The photovoltaic field is estimated from the thickness of the active layer, thus the photovoltaic field is the photovoltage divided by the distance between electrodes.

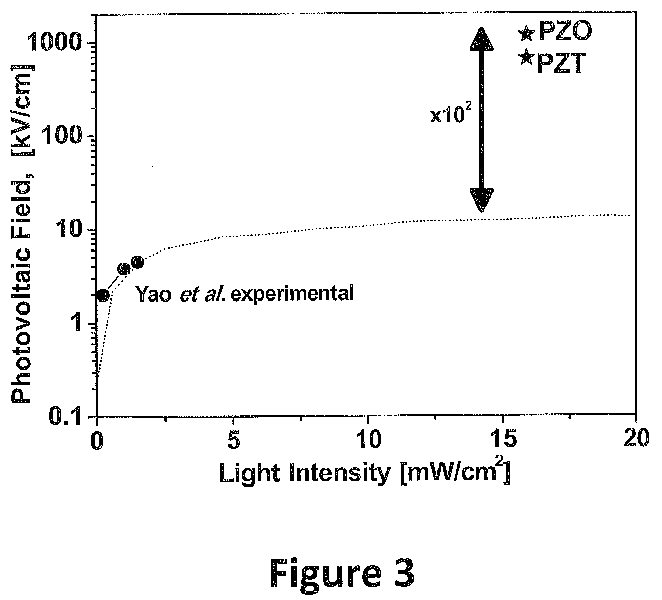

**Figure 3** is a graph showing the photovoltaic electric field improvement of two orders of magnitude when comparing the invention (∼1MV/cm) with the prior state of the art (∼1-10k V/cm).

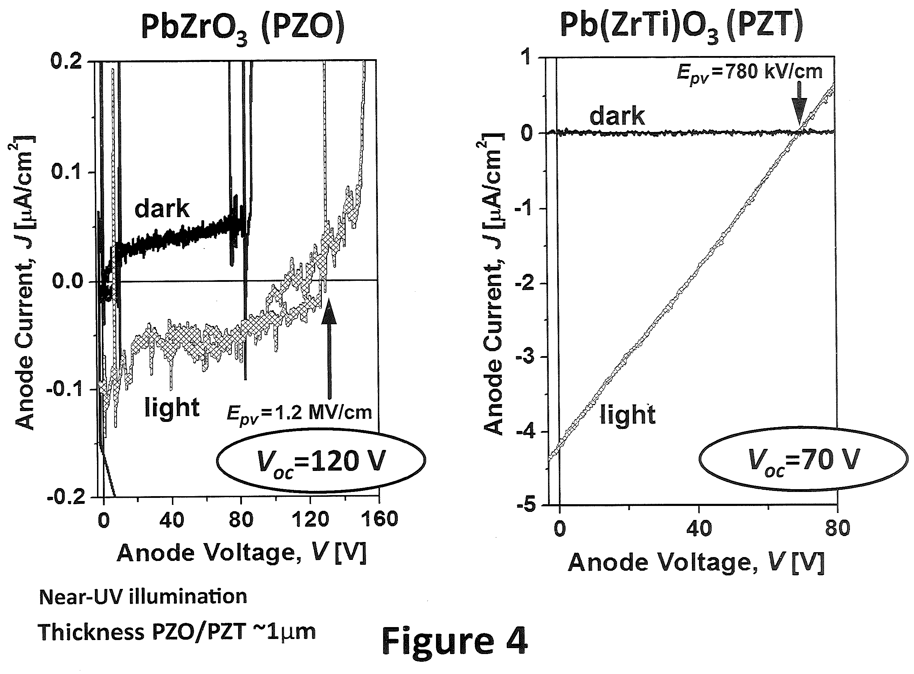

**Figure 4** shows the experimental results for average PZT and PZO 3L photodiodes illustrating the large above-bandgap voltages and the related outstanding photovoltaic fields. This outstanding enhancement lies in the use of vertical structures (instead of lateral) and the use of ferroelectric/antiferroelectric internal fields.

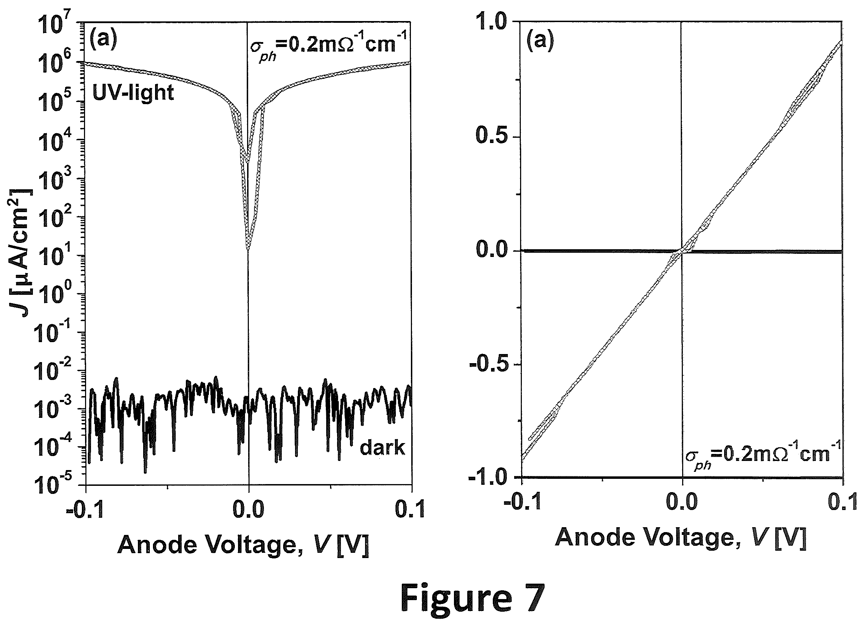

Ferroelectric and antiferroelectric orientable dipoles are in the basis on the invention. **Figure 5** shows typical polarization-voltage characteristics for ferroelectric (PZT) and antiferroelectric (PZO) active layers where photodiodes have been fabricated exhibiting large above-bandgap voltages. The PZT layer has been grown with a double thermal process after the spin coating of a Pb-Zr-Ti solution. In short, after the spin coating, the Pb-Zr-Ti layer was dried at 150°C on a hot plate for 5 min, then annealed in air at 400°C-650°C for 10 min, and optionally oxidized in O₂ at 550°C-650°C. Each particular sample condition of growth will be referred to with the notation *Tₐₙ*/*Tₒₓ.* Twenty different PZT fabrication routes have been tested varying such a combination. The Pb(Zr_{0.53}Ti_{0.47})O₃ final thickness depends on the number of spin coating cycles, the spin velocity and acceleration. Reference PZT layers have been formed after three spin coating cycles with 4000 rpm (40 s) and 2000 rpm/s. The reference device final thickness is approximately 900 nm-thick, as determined by x-sectional focused ion beam images. For annealing/oxidation temperatures larger than 550°C, the x-ray diffraction patterns show perovskite PZT phase formation. A ferroelectric characterization system was used to measure polarization-voltage (P-V) loops and to determine the main PZT ferroelectric properties including remnant polarization (*Pᵣ*), maximum polarization (*Pₘₐₓ*) and coercive field (*E_{c}*) as shown in Fig. 7. The measurement frequency was 20 ms. In general, *Pₘₐₓ* and *Pᵣ* are larger for oxidation temperatures in the range of 600-625°C. The largest *Pₘₐₓ* values have been found for 0/600, 0/625, 650/625 and 400/650 to be around 40 µC/cm². Analogously, the largest remnant polarization was found for 0/625 to be around 30 µC/cm² but the rest of the large *Pₘₐₓ* group also has *Pᵣ*>20 µC/cm². This also correlates with a smaller coercive (positive) field, except for 400/650 showing small imprint. An atomic force microscope (AFM) was used to reveal the morphology pattern of the PZT. The perovskite phase formation is also linked with a relevant roughening of the surface. Any sample reaching 650°C has a significant rms roughness (rms> 10 nm), except the sample with no previous annealing. The reason for the un-annealed relative flatness is due to a slower heating ramp in the oxidation furnace. Analogously, a ferroelectric characterization system (Radiant RT66) was used to measure polarization-voltage (P-V) loops and to determine the main antiferroelectric PZO properties. An antiferroelectric (AFE) phase turns into a ferroelectric (FE) phase as the result of an adequate electric field stress, temperature stress or hydrostatic pressure. In an AFE to FE transition, dipoles re-align in the same orientation within a domain. The phase transition is always accompanied by a remarkable and sharp change in polarization and volume. At the lowest electric fields, the random arranged AFE domains are re-aligned. The result is a straight line in the P-V hysteresis loop curve. Then, re-aligned AFE domains are transformed into FE state at the critical forward phase switching field. By further increasing the electric field, the polarization orientation of the induced FE domains was rearranged and the piezoelectric effect in the induced FE state appears at the even higher electric field. Similarly, as electric field is decreased from maximum values to zero, the system undergoes an FE to AFE transition at the backward switching field. The voltage required for the AFE to FE transition is in the range of 14-30 V corresponding to an electric field of 100-300 kV/cm. The device also exhibits larger polarization (20 µC/cm²). The hysteresis loop maximum voltage was increased between 40 V and 80 V. The device did not suffer dielectric breakdown or signs of degradation.

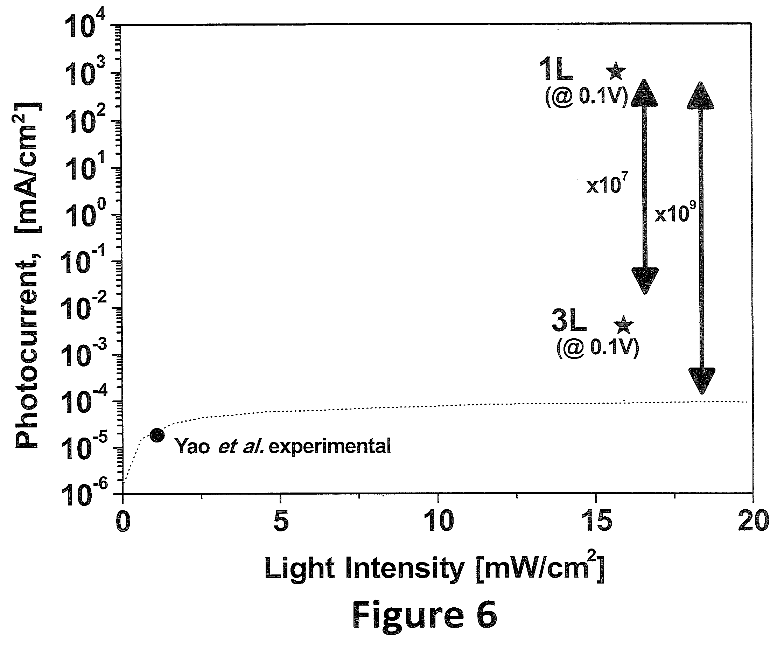

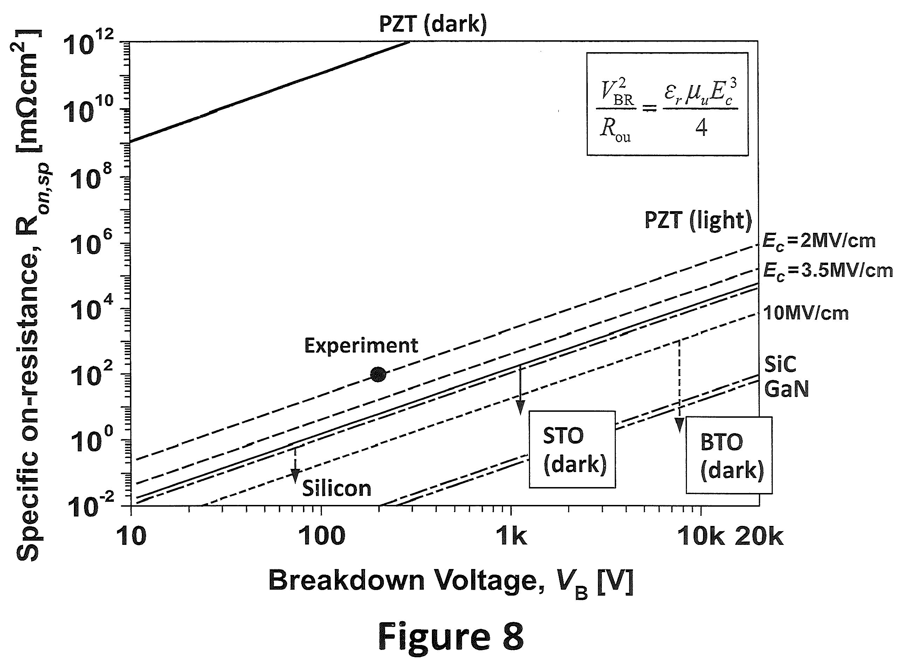

Photodiodes with very large photocurrent are obtained if the thickness of the active area thin-film is reduced from 900 nm (three spin coating cycles, i.e., 3L) to 300 nm (one single spin coating cycle, i.e., 1 L). The photodiode internal field for 1 L extends the entire thin-film resulting in a *punch-through* photodiode where instead of achieving large photovoltages, very large photocurrents are obtained **(****Figure 6****).** The condition to achieve a large voltage is the series combination of a low resistive drift region (depleted region due to the photovoltaic field) and a highly resistive region. When the device becomes thinner (i.e. one single layer instead of three but with identical processing and structure), the photovoltaic field encompasses all the device area so any photogenerated carrier is accelerated without the limitation of any contact barrier. There are nine orders of magnitude of difference between illuminated (on) and dark (off) so there is a possibility of conceiving this device as a power switch. The experimental responsiveness is as great as 63 A/W at *V* =0.1 V (5 kV/cm). The primary photocurrent is 0.3 mA/cm². The gain of the photodiode is then as large as *G* =3250. The gain depends on the ratio of carrier lifetime to transit time. For long-lifetime photoconductors with short electrode spacing, the gain can be substantially greater than unity. This is a first demonstration. There are no ferroelectric/antiferroelectric *punch-through* photodiodes available in the literature for comparison. The 1 L device can obviously be used as a UV photodetector but it also has other potential applications, such as a power switch where the switching state is accomplished via illumination through the thin-film. In the dark, the device is very resistive (σ < 10⁻¹² Ω⁻¹cm⁻¹) while under illumination the device is very conductive (σ < 10⁻² Ω⁻¹cm⁻¹). The on-off ratio is more than 10⁹ orders of magnitude as shown in **Figure 7****.** In the dark, the thin-film can sustain more than 200V (depending on the conditions of growth). For this reason, the invention can further be used as a power switch, where the switching state is accomplished via illumination through the thin-film. As can be seen in **Figure 6****,** in the dark, the device is very resistive (σ < 10⁻¹² Ω⁻¹cm⁻¹) while under illumination the device is very conductive (σ < 10⁻² Ω⁻¹cm⁻¹). The on-off ratio is more than 10⁹ orders of magnitude. In the dark, the thin-film can sustain more than 200 V (depending on the conditions of growth). The process is extremely straightforward and fast if compared to conventional fabrication methods for power switches where cleanrooms and single-crystal materials are required. **Figure 8** shows the well-known on-resistance vs. breakdown voltage factor of merit diagram for a power switch device and how the 1 L device compares well with the state of the art. Nevertheless, 1 L photodiode is a polycrystalline, low-cost and straightforward device made outside a clean-room for the first time.

As it is used herein, the term "comprises" and derivations thereof (such as "comprising", etc.) should not be understood in an excluding sense, that is, these terms should not be interpreted as excluding the possibility that what is described and defined may include further elements, steps, etc.

On the other hand, the invention is obviously not limited to the specific embodiment(s) described herein, but also encompasses any variations that may be considered by any person skilled in the art (for example, as regards the choice of materials, dimensions, components, configuration, etc.) to be within the general scope of the invention as defined in the claims.

## Claims

1. Photodiode comprising a transparent fluorine-doped tin oxide (FTO) layer on a substrate, an active layer of a wide-gap semiconductor with orientable polarization of a thickness of less than 1µm and an ionizable metal layer in this order, and wherein the active layer has been annealed for 30 seconds to 30 minutes at a temperature between 600°C and 625°C in air

2. Photodiode according to claim 1, wherein the active layer is one or a combination of the following materials: Pb(ZrTi)O₃ (PZT), YMnO₃ (YMO), BiFeO₃ (BFO) or PbZrO₃ (PZO).

3. Photodiode according to claim 1 or 2, wherein the ionizable metal is silver.

4. Photodiode according to claim 1 or 2, wherein the active layer has been further oxidized in O₂.

5. Tandem photovoltaic cell comprising the photodiode of any of the previous claims and a semiconductor layer on top of the ionizable metal, the semiconductor comprising one or a mixture of the following compounds: metal-halide perovskites, [CH₃NH₃] XY₃ where X is Pb or Sn and Y is I, Br or Cl, organic photovoltaic semiconductor blends such as the regioregular poly (3-hexylthiophene) (P3HT) and phenyl-C61-butyric acid methyl ester (PCBM) or P3HT:PCBM, NiO, V2O5, WO3, MoO3, ZnO or TiO₂.

6. Use of the photodiode of any of claims 1-4 as a self-cleaning surface.
